# EUROPÄISCHE PATENTANMELDUNG

(11) **EP 0 682 246 A1**
(43) Veröffentlichungstag der Anmeldung: **15.11.1995**
(21) Anmeldenummer: 95106793.3
(22) Anmeldetag: 05.05.1995
(51) Int. Cl.: G01N 27/02, G01N 27/07, G01R 27/22

(54) **Sensor zur Messung der Leitfähigkeit flüssiger Medien**

(30) Priorität: 13.05.1994 DE 4416892
(71) Anmelder: ENDRESS + HAUSER CONDUCTA GESELLSCHAFT FÜR MESS UND REGELTECHNIK mbH & Co., D-70839 Gerlingen (DE)
(72) Erfinder: Schrettenbrunner, Manfred, Dr., D-70839 Gerlingen (DE)
(74) Vertreter: Otte, Peter, Dipl.-Ing.

(57) **Zusammenfassung**

Um einen Sensor zur Messung der Leitfähigkeit flüssiger Medien mit einem in das flüssige Medium im wesentlichen senkrecht zu dessen Strömung hineinragenden Meßteil und mit einem vom flüssigen Medium durchströmten axial in Strömungsrichtung des flüssigen Mediums im Meßteil angeordneten Durchtrittsrohrs dahingehend zu verbessern, daß der Sensor strömungsdynamisch optimiert ist, wird vorgeschlagen, daß das Meßteil eine strömungsdynamisch optimierte Gestalt aufweist und daß das Durchtrittsrohr in Strömungsrichtung des flüssigen Mediums konisch ausgebildet ist.

## Beschreibung

Die Erfindung betrifft einen Sensor zur Messung der Leitfähigkeit flüssiger Medien nach dem Oberbegriff des Patentanspruchs 1.

Um die Leitfähigkeit flüssiger, beispielsweise in einem Rohr kreisförmigen Querschnitts fließender Medien zu messen, werden seit langem Sensoren mit einer einfachen zylindrischen Geometrie verwendet. In einem kreiszylinderförmigen Sensorkörper ist eine, als Durchtrittsrohr für das strömende flüssige Medium wirkende ebenfalls kreiszylinderförmige Öffnung, beispielsweise in Form einer Bohrung, angeordnet. Der Sensorkörper ist in der in dem Rohr strömenden Flüssigkeit derart positioniert, daß seine Symmetrieachse senkrecht zur Strömungsrichtung der Flüssigkeit angeordnet ist. Die kreiszylindrische Öffnung, das Durchtrittsrohr, verläuft im Sensorkörper parallel oder senkrecht zur Strömungsrichtung der strömenden Flüssigkeit. Auf diese Weise wird der kreiszylinderförmige Sensorkörper einerseits von der strömenden Flüssigkeit umströmt, andererseits strömt ein Teil der Flüssigkeit durch die Öffnung im Sensorkörper.

Zur Messung der Leitfähigkeit des strömenden Mediums sind nun in an sich bekannter Weise im Sensorkörper konzentrisch um die im Sensorkörper angeordnete Öffnung zwei Spulen angeordnet, an deren einer eine Spannung angelegt wird, wodurch vermittelt durch die strömende, leitfähige Flüssigkeit in der anderen eine Induktionsspannung erzeugt wird, die einen in der zweiten Spule fließenden Strom zur Folge hat. Ohne Medium ist das Spulenpaar so abgeglichen, daß in der zweiten Spule keine Spannung induziert wird und damit auch kein Strom fließt. Strömt nun das Medium durch die kreiszylinderförmige Öffnung im Sensorkörper, so wird die von der Leitfähigkeit abhängige Kopplung des Spulenpaares verändert. Die Kopplung ist ein Maß für die Leitfähigkeit des Mediums.

Derartige Leitfähigkeitssensoren weisen nun den Nachteil auf, daß sie aufgrund ihrer senkrecht zur Strömung des flüssigen Mediums angeordneten kreiszylinderförmigen Gestalt ein großes Verdrängungsvolumen bilden, wodurch sich ein großer Staudruck ergibt. Außerdem können sich aufgrund der einfachen Geometrie des Leitfähigkeitssensors turbulente Strömungen bilden, die ihrerseits zur Gasblasenbildung im strömenden Medium führen, welche die Messung der Leitfähigkeit nachteilig beeinflusssen. Diese turbulenten Strömungen treten insbesondere auch an dem vom Medium durchströmten Durchtrittsrohr auf.

Aufgabe der Erfindung ist es, einen Leitfähigkeitssensor zu vermitteln, der strömungsdynamisch derart optimiert ist, daß turbulente Strömungen minimiert werden, eine gute Anströmung des Sensors erzielt wird, und daß darüber hinaus soweit wie möglich Gasblasenbildung in der Strömung und damit auch im Durchtrittsrohr vermieden werden bzw. gegebenenfalls vorhandene Gasblasen leicht und schnell aus dem Durchtrittsrohr wegtransportiert werden, und daß darüber hinaus die Möglichkeit, daß sich beispielsweise feste Bestandteile der Flüssigkeit im Durchtrittsrohr festsetzen können, verhindert wird.

Die Aufgabe wird bei einem gattungsgemäßen Sensor zur Messung der Leitfähigkeit flüssiger Medien erfindungsgemäß durch die Merkmale des Kennzeichnungsteils des Anspruchs 1 gelöst.

Durch die konische Ausbildung des Durchtrittsrohrs derart, daß das Durchtrittsrohr auf der Anströmseite einen kleineren Durchmesser beziehungsweise Querschnitt als auf der Abströmseite aufweist, nimmt die Geschwindigkeit der durch das Durchtrittsrohr fließenden Strömung zur Abströmseite des Durchtrittsrohrs hin allmählich ab, da die Strömung in einem Rohr mit einem größeren Querschnitt eine geringere Geschwindigkeit aufweist als in einem Rohr mit einem kleineren Querschnitt. Aufgrund dieses Geschwindigkeitsgradienten und der durch ihn bewirkten kleineren Geschwindigkeit an der Abströmseite des Durchtrittsrohrs, das heißt an dessen Auslaß, wird eine Strömungsberuhigung erzielt und dadurch die Tendenz zur Bildung von Turbulenzen minimiert wird. Darüber hinaus hat die konische Gestalt des Durchtrittsrohrs auch den Vorteil, daß sich eventuell im Durchtrittsrohr befindliche Gasbläschen leichter wegtransportiert werden können bzw. ihrer Neigung, an dessen Oberfläche zu haften, entgegengewirkt wird.

Dadurch, daß das Meßteil des Sensors an der Anströmseite vorteilhafterweise strömungsdynamisch optimiert verrundete Kanten aufweist, derart, daß der Strömung nur gekrümmte Flächen entgegenstehen, stellt es der auf ihn auftreffenden Flüssigkeitsströmung einen weit geringeren Strömungswiderstand entgegen, als es bei bekannten, senkrecht zur Flüssigkeitsströmung angeordneten kreiszylinderförmigen Meßteilen der Fall ist.

Schließlich trägt zum optimalen Strömungsverhalten des Sensors bei, daß das Meßteil auf der Abströmseite eine im wesentlichen glatte, ebene und zur Strömungsrichtung im wesentlichen orthogonale Abrißkante aufweist. Dadurch wird die Bildung turbulenter Strömungen an der Abströmseite des Sensors und insbesondere im vom Medium durchströmten Durchtrittsrohr minimiert.

Vorteilhaft ist es auch, daß das Meßteil in Strömungsrichtung des flüssigen Mediums eine im wesentlichen kreiszylindrische Gestalt aufweist, da auf diese Weise der Sensor besser umströmt wird und das Strömungsverhalten dadurch weiter optimiert ist.

Vorzugsweise ist an dem Meßteil des Sensors eine in das Medium hineinragende Wärmeleitbuchse befestigbar, so daß die Temperatur des strömenden Mediums gleichzeitig mit der Leitfähigkeit des Mediums am Sensor selbst gemessen werden kann.

Des weiteren ist es vorteilhaft, daß das Meßteil wahlweise auch auf einem in das flüssige Medium hineinragenden stabförmigen, ebenfalls strömungsdynamisch optimierten Verlängerungsteil befestigbar ist, ohne daß sein Strömungsverhalten nachteilig verändert wird. Auf diese Weise kann die Strömung beispielsweise in einem Rohr größeren Querschnitts exakt in der Symmetrieachse des Rohrs gemessen werden. Dabei läßt sich das Verlängerungsteil auf beliebig große Rohrquerschnitte anpassen.

Zur Messung der Temperatur kann in diesem Falle eine Wärmeleitbuchse vorzugsweise auch an dem Verlängerungsrohr angeordnet werden.

Besonders vorteilhaft ist es, daß die Wärmeleitbuchse spaltenfrei und mittels eines an der Sensorgehäuse-Außenwand angeordneten O-Rings abgedichtet befestigbar ist. Dadurch läßt sich der Leitfähigkeitssensor insbesondere auch in der Lebensmittelindustrie einsetzen, bei der jegliche Art von Spalten am Sensor vermieden werden müssen, da sich in den Spalten Lebensmittelreste festsetzen können, und sich dadurch der Sensor nur sehr schwer reinigen und daraufhin sterilisieren läßt. Beim erfindungsgemäßen Sensor werden derartige Spalten vermieden, so daß er leicht reinigbar und sterilisierbar und deshalb besonders gut in der Lebensmittelindustrie verwendbar ist.

Die nachstehende Beschreibung bevorzugter Ausführungsformen der Erfindung dient im Zusammenhang mit beiliegender Zeichnung der weiteren Erläuterung.

Es zeigen:
- Fig. 1: eine teilweise geschnittene Seitenansicht eines Sensors zur Messung der Leitfähigkeit flüssiger Medien;
- Fig. 2: eine entlang der Linie II-II geschnittene Darstellung des Sensors der Fig. 1;
- Fig. 3: eine teilweise geschnittene Seitenansicht einer weiteren Ausführungsform eines Sensors zur Messung der Leitfähigkeit flüssiger Medien;
- Fig. 4: eine Schnittdarstellung des Leitfähigkeitssensors entlang der Linie IV-IV der Fig. 3 und
- Fig. 5: eine Schnittdarstellung, welche die Befestigung einer Wärmeleitfähigkeitsbuchse am Sensor schematisch verdeutlicht.

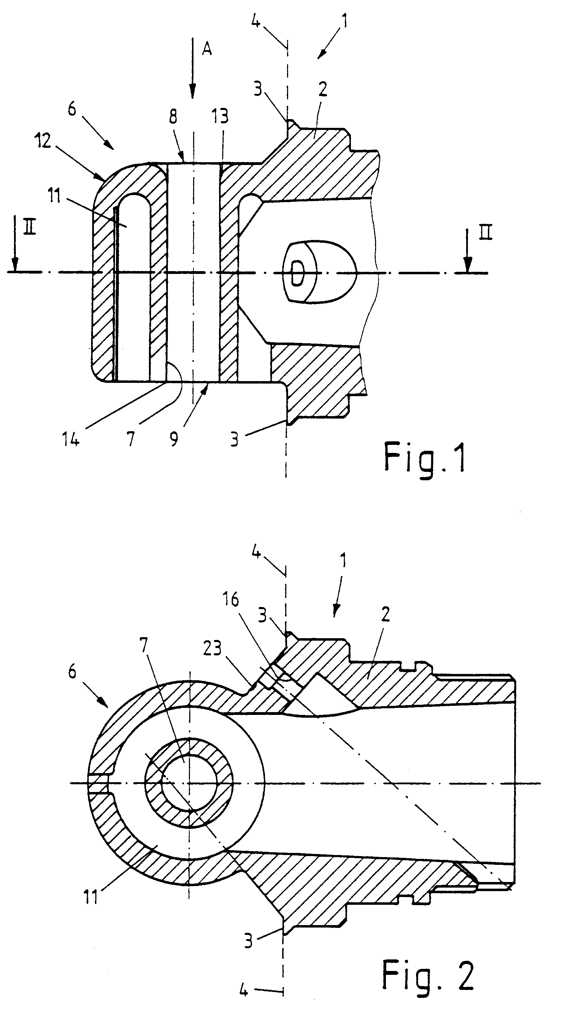

Wie in Fig. 1 dargestellt, umfaßt ein Sensor 1 zur Messung der Leitfähigkeit flüssiger Medien einen Sensorkörper 2, der zur Befestigung an einer Rohrwand 4 einen Flansch 3 aufweist.

Von der Rohrwand 4 senkrecht abstehend ragt in das Rohr senkrecht zu der im Rohr entlang des dargestellten Pfeiles A strömenden Flüssigkeit ein Meßteil 6. Das Meßteil 6 weist axial in Strömungsrichtung des flüssigen Mediums ein Durchtrittsrohr 7 auf. Das Durchtrittsrohr 7 ist derart konisch ausgebildet, daß es an seiner Anströmseite 8, das heißt an seiner der Strömung zugewandten Seite, einen kleineren Durchmesser beziehungsweise Querschnitt aufweist als an seiner Abströmseite 9, das heißt an seiner der Strömung abgewandten Seite. Wie in Fig. 1 und 2 dargestellt, ist in dem Meßteil 6 konzentrisch zum konischen Durchtrittsrohr 7 ein ringförmiger Hohlraum 11 angeordnet. Der Hohlraum 11 dient zur Aufnahme an sich bekannter (nicht dargestellter) Meßspulen. Im Hohlraum 11 sind die Meßspulen in Form eines Spulenpaares in Strömungsrichtung (Pfeil A) hintereinanderliegend angeordnet (nicht dargestellt), wobei die Kopplung der beiden Spulen durch das durch das Durchtrittsrohr 7 strömende Medium vermittelt wird.

Damit das Meßteil 6 strömungsdynamisch eine optimale Gestalt aufweist, so daß eine turbulente Strömung an irgendeiner Stelle des Meßteils 6 sowie insbesondere an der Anströmseite 8 und/oder an der Abströmseite 9 minimiert wird, umfaßt das Meßteil 6 an seiner Anströmseite 8 verrundete Kanten 12, 13, die strömungsdynamisch in an sich bekannter Weise optimiert sind, sowie an seiner Abströmseite 9 eine im wesentlichen glatte, ebene, zur Strömungsrichtung im wesentlichen orthogonale Abrißkante 14. Die Radien der verrundeten Kanten 12, 13 weisen vorteilhafterweise einen Wert auf, der größer oder gleich 1,6 mm ist. Hierdurch läßt sich der Sensor besonders gut reinigen und sterilisieren, da er von bekannten Reinigungs- und Sterilisierungsflüssigkeiten gut umspült und benetzt wird. Aus diesem Grunde ist der Sensor besonders für den Einsatz in der Lebensmittelindustrie geeignet.

Darüber hinaus hat das Meßteil 6 in Strömungsrichtung des flüssigen Mediums (Pfeil A) eine im wesentlichen kreiszylindrische Gestalt (Fig. 2), was ebenfalls den Strömungswiderstand verringert und eine optimale Umströmung des Meßteils 6 ermöglicht.

Die abgerundeten Kanten 12, 13, die glatte Abrißkante 14 sowie die in Strömungsrichtung gesehen kreiszylindrische Gestalt des Meßteils 6 ermöglichen eine optimale, das heißt Turbulenzen vermeidende Umströmung des Meßteils 6.

Gemeinsam mit der beschriebenen strömungsdynamisch optimierten Gestalt des Meßteils 6 trägt die konische Ausbildung des Durchtrittsrohrs 7 zu einer Strömungsberuhigung bei. Durch die konische Gestalt bildet sich nämlich in Strömungsrichtung des flüssigen Mediums ein von der Anströmseite 8, das heißt vom kleineren Durchmesser beziehungsweise Querschnitt des Durchtrittsrohrs 7, zur Abströmseite 9 hin, das heißt zum größeren Durchmesser beziehungsweise Querschnitt des Durchtrittsrohrs 7 hin, abnehmender Geschwindigkeitsgradient der Strömung aus, so daß das flüssige Medium an der Abströmseite 9 mit einer geringeren Geschwindigkeit als auf der Anströmseite 8 strömt, wodurch ebenfalls eine Neigung zu Turbulenzen an der Abströmseite 9 minimiert wird. Derartige Turbulenzen führen zu der Bildung von Gasbläschen, welche das Meßergebnis stören. Gerade auch durch die Kombination des strömungsdynamisch optimierten Meßteils 6 und des konisch ausbildeten Durchtrittsrohrs 7 wird eine besonders gute Umströmung des Meßteils und eine gute Durchströmung des Durchtrittsrohrs 7 ermöglicht, eine Entstehung von Gasbläschen weitgehend vermieden und dadurch wiederum eine präzise Messung ermöglicht.

Des weiteren wird durch den konischen Verlauf die Wahrscheinlichkeit, daß eventuell in der strömenden Flüssigkeit sich befindliche feste Bestandteile das Durchtrittsrohr zusetzen und damit den Durchfluß der Flüssigkeit hindern und folglich das Meßergebnis verfälschen, vermindert. Denn eine Voraussetzung für eine ordnungsgemäße Meßung ist das Strömen der Flüssigkeit.

Zudem ermöglicht der konische Verlauf des Durchtrittsrohrs 7 ein leichteres Wegtransportieren eventuell doch entstandener Gasbläschen aufgrund seines an der Abströmseite 9 größeren Durchmessers.

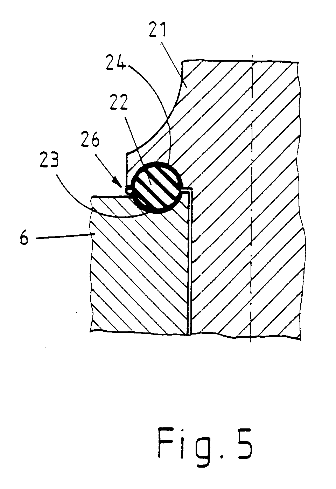

Wie weiterhin aus Fig. 2 hervorgeht, ist an dem Meßteil 6 eine Öffnung 16 zur Befestigung einer in das Medium hineinragenden, an sich bekannten Wärmeleitbuchse 21 (in Fig. 2 nicht dargestellt; siehe Fig. 5) vorgesehen.

Die Wärmeleitbuchse 21 ist an dem Meßteil 6 spaltenfrei befestigbar. Auch dies ist - neben dem oben angegebenen Radius der verrrundeten Kanten - Bedingung für einen Einsatz des Leitfähigkeitssensors in der Lebensmittelindustrie. Denn gerade in der Lebensmittelindustrie muß darauf geachtet werden, daß keinerlei Spalten entstehen, in denen sich Lebensmittelreste festsetzen können, deren Zersetzung, Fäulnis, Schimmelbildung etc. das zu messende Lebensmittel negativ beeinträchtigen oder zerstören.

Aus diesem Grunde ist die Wärmeleitbuchse an der äußeren Wand des Meßteils 6 auch mittels einer an sich bekannten Kunststoffdichtung (O-Ring) 22 abgedichtet befestigbar.

Die spaltfreie und abgedichtete Befestigung der Wärmeleitbuchse 21 geht am deutlichsten aus Fig. 5 hervor. An dem Meßkörper 6 ist konzentrisch um die Öffnung 16 eine den O-Ring 22 nahezu zur Hälfte aufnehmende, komplementär zur äußeren Form des O-Rings 22 ausgebildete Ausnehmung 23 vorgesehen. In der Wärmeleitbuchse 21 ist in einem schulterförmigen, ringförmig umlaufenden Vorsprung eine dieser Ausnehmung entsprechende, gegenüberliegende Ausnehmung 24 ausgebildet. Der O-Ring 22 befindet sich zwischen den beiden Ausnehmungen 23, 24. Er wird im montierten Zustand der Wärmeleitbuchse 21 derart in einen dafür vorgesehenen Spalt 26 zwischen dem Meßteil 6 und dem ringförmig umlaufenden, schulterförmigen Vorsprung der Wärmeleitbuchse 21 gedrückt, daß er im Medium nahezu eben und daher spaltfrei sowohl mit der sich im Medium befindlichen äußeren Begrenzungsfläche des Meßteils 6 als auch der Wärmeleitbuchse 21 abschließt.

Die Wärmeleitbuchse 21 ragt in die strömende Flüssigkeit hinein, wodurch gleichzeitig die Leitfähigkeit und die Temperatur der Flüssigkeit gemessen werden können.

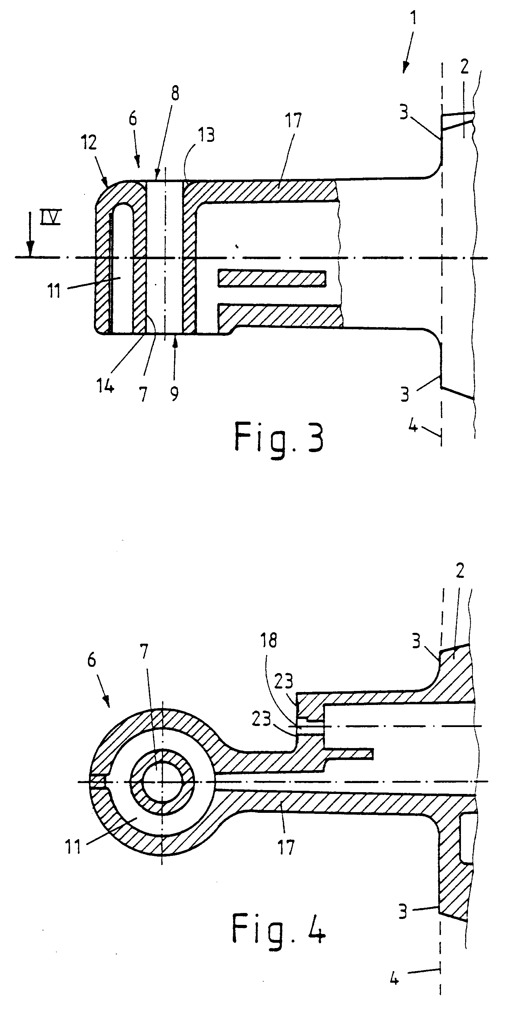

Die in Fig. 3, 4 dargestellte Ausführungsform unterscheidet sich von der in Fig. 1, 2 dargestellten Ausführungsform nur darin, daß zwischen dem Flansch 3 und dem Meßteil 6 ein stabförmiges Verlängerungsteil 17 angeordnet ist, wodurch sich der Einsatz des Sensors auch in von dem zu messenden Medium durchströmten Rohren großen Durchmessers einsetzen läßt.

Das Verlängerungsteil 17 ist derart strömungsdynamisch optimiert, daß seine der Strömungsrichtung zugewandte Fläche derart gekrümmt ist, daß sie dem strömenden Medium einen geringen Strömungswiderstand entgegengesetzt. Zu diesem Zweck ist auch die zur Strömungsrichtung orthogonale Projektionsfläche des Verlängerungsteils 17 minimiert.

Durch das Verlängerungsteil 17 kann das Durchtrittsrohr 7 immer exakt in der Symmetrieachse des durchströmten Rohres und daher in der Mittelachse der Strömung angeordnet werden. Am Verlängerungsteil 17 ist eine Öffnung 18 zur Aufnahme der (in Fig. 4 nicht dargestellten) Wärmeleitbuchse vorgesehen, die zusammen mit dem Meßteil 6 in die strömende Flüssigkeit hineinragt. Die Wärmeleitbuchse ist auch in diesem Fall, wie oben beschrieben, spaltenfrei und mittels eines bekannten O-Rings abgedichtet befestigbar.

## Patentansprüche

1. Sensor zur Messung der Leitfähigkeit flüssiger Medien mit einem in das flüssige Medium im wesentlichen senkrecht zu dessen Strömung hineinragenden Meßteil und mit einem vom flüssigen Medium durchströmten, axial in Strömungsrichtung des flüssigen Mediums im Meßteil angeordneten Durchtrittsrohr,
**dadurch gekennzeichnet,**
daß das Meßteil (6) eine strömungsdynamisch optimierte Gestalt aufweist, und
daß das Durchtrittsrohr (7) in Strömungsrichtung des flüssigen Mediums konisch ausgebildet ist.

2. Sensor nach Anspruch 1, **dadurch gekennzeichnet,** daß das Meßteil (6) an seiner Anströmseite (8) strömungsdynamisch optimiert verrundete Kanten (12, 13) aufweist.

3. Sensor nach Anspruch 1 oder 2, **dadurch gekennzeichnet,** daß die verrundeten Kanten (12, 13) einen Radius aufweisen, der größer oder gleich 1,6 mm ist.

4. Sensor nach Anspruch 1, 2 oder 3, **dadurch gekennzeichnet,** daß das Meßteil (6) auf seiner Abströmseite (9) eine im wesentlichen glatte, ebene Abrißkante (14) aufweist.

5. Sensor nach einem der vorstehenden Ansprüche, **dadurch gekennzeichnet,** daß das Durchtrittsrohr (7) auf der Anströmseite (8) einen kleineren Durchmesser beziehungsweise Querschnitt aufweist als auf der Abströmseite (9).

6. Sensor nach einem der vorstehenden Ansprüche, **dadurch gekennzeichnet,** daß das Meßteil (6) in Strömungsrichtung des flüssigen Mediums eine im wesentlichen kreiszylindrische Gestalt aufweist.

7. Sensor nach einem der vorstehenden Ansprüche, **dadurch gekennzeichnet,** daß in dem Meßteil (6) konzentrisch zum konischen Durchtrittsrohr (7) ein ringförmiger Hohlraum (11) zur Aufnahme an sich bekannter Meßspulen angeordnet ist.

8. Sensor nach einem der vorstehenden Ansprüche, **dadurch gekennzeichnet,** daß an dem Meßteil (6) eine in die strömende Flüssigkeit hineinragende Wärmeleitbuchse (21) befestigbar ist.

9. Sensor nach einem oder mehreren der Ansprüche 1 bis 7, **dadurch gekennzeichnet,** daß das Meßteil (6) auf einem in das flüssige Medium hineinragenden, stabförmigen, strömungsdynamisch optimierten Verlängerungsteil (17) befestigbar ist.

10. Sensor nach Anspruch 9, **dadurch gekennzeichnet,** daß die in das Medium hineinragende Wärmeleitbuchse (21) an dem Verlängerungsteil (17) befestigbar ist.

11. Sensor nach einem der vorstehenden Ansprüche, **dadurch gekennzeichnet,** daß die Wärmeleitbuchse (21) spaltenfrei befestigbar ist.

12. Sensor nach Anspruch 11, **dadurch gekennzeichnet,** daß die Wärmeleitbuchse (21) mittels eines an einer Außenwand des Meßteils (6) angeordneten O-Rings (22) abgedichtet befestigbar ist.

13. Sensor nach Anspruch 11 oder 12, **dadurch gekennzeichnet,** daß am Meßteil (6) zur Aufnahme des O-Rings (22) eine komplementär zu diesem ausgebildete Ausnehmung (23) vorgesehen ist.

14. Sensor nach einem der vorstehenden Ansprüche, **dadurch gekennzeichnet,** daß in einem ringförmig umlaufenden, schulterförmigen Vorsprung der Wärmeleitbuchse (21) zur Aufnahme des O-Rings (22) eine zu diesem komplementär ausgebildete Ausnehmung (24) vorgesehen ist.

15. Sensor nach einem der vorstehenden Ansprüche, **dadurch gekennzeichnet,** daß im montierten Zustand der Wärmeleitbuchse (21) zwischen dem Meßteil (6) und dem ringförmig umlaufenden, schulterförmigen Vorsprung ein Spalt (26) vorgesehen ist, in welchen der O-Ring (22) so hineindeformiert wird, daß er sowohl mit der Außenfläche des Meßteils (6) als auch mit jener der Wärmeleitbuchse (21) eben und spaltfrei abschließt.
